(19) Europäisches Patentamt / European Patent Office / Office européen des brevets

(11) **EP 4 391 738 A1**

(12) **EUROPEAN PATENT APPLICATION**
published in accordance with Art. 153(4) EPC

(43) Date of publication:
**26.06.2024 Bulletin 2024/26**

(21) Application number: **22858369.6**

(22) Date of filing: **08.08.2022**

(51) International Patent Classification (IPC):
*H05K 1/16* (2006.01)          *H01C 1/146* (2006.01)
*H01C 7/00* (2006.01)

(52) Cooperative Patent Classification (CPC):
**H01C 1/146; H01C 7/00; H05K 1/16**

(86) International application number:
**PCT/JP2022/030296**

(87) International publication number:
**WO 2023/022048 (23.02.2023 Gazette 2023/08)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **20.08.2021 JP 2021134951**

(71) Applicant: **KYOCERA CORPORATION**
**Kyoto-shi,**
**Kyoto 612-8501 (JP)**

(72) Inventor: **KURAMOTO, Yoshio**
**Kyoto-shi, Kyoto 612-8501 (JP)**

(74) Representative: **Viering, Jentschura & Partner mbB**
**Patent- und Rechtsanwälte**
**Am Brauhaus 8**
**01099 Dresden (DE)**

(54) **CIRCUIT BOARD AND ELECTRONIC DEVICE**

(57)    A circuit substrate includes a substrate body made of a ceramic, wiring located on the substrate body, and a resistor interposed in the wiring and having an electrical resistance higher than that of the wiring. The wiring includes a first electrode and a second electrode. The first electrode includes a first body portion and a plurality of first comb-tooth portions each extending from the first body portion in a direction intersecting a direction in which the first body portion extends. The second electrode includes a second body portion and a plurality of second comb-tooth portions, each extending from the second body portion in a direction intersecting a direction in which the second body portion extends, and has a comb-tooth shape located to mesh with a comb-tooth shape of the first electrode with an interval. The resistor includes a resistive element located in contact with both the first body portion of the first electrode and the second body portion of the second electrode.

FIG. 4

## Description

### TECHNICAL FIELD

An embodiment of the present disclosure relates to a circuit substrate and an electronic device.

### BACKGROUND OF INVENTION

Since a substrate made of a ceramic has superior insulating properties, superior thermal conductivity, and the like, the substrate may be utilized as a circuit substrate for a lighting device such as an on-board lamp. The circuit substrate is provided with a resistor for adjusting a current flowing through a light emitting element such as a light emitting diode (LED) (for example, see Patent Document 1).

### CITATION LIST

### PATENT LITERATURE

Patent Document 1: JP 09-326540 A

### SUMMARY

A circuit substrate according to an aspect of an embodiment includes a substrate body made of a ceramic, wiring located on the substrate body, and a resistor interposed in the wiring and having a higher electrical resistance than the wiring. The wiring includes a first electrode and a second electrode. The first electrode includes a first body portion and a plurality of first comb-tooth portions each extending from the first body portion in a direction intersecting a direction in which the first body portion extends. The second electrode includes a second body portion and a plurality of second comb-tooth portions, each extending from the second body portion in a direction intersecting a direction in which the second body portion extends, and has a comb-tooth shape located so as to mesh with a comb-tooth shape of the first electrode with an interval. The resistor includes a resistive element located in contact with both the first body portion of the first electrode and the second body portion of the second electrode.

### BRIEF DESCRIPTION OF THE DRAWINGS

FIG. 1 is a schematic side view of a lighting device according to an embodiment.
FIG. 2 is a schematic perspective view of a socket according to the embodiment.
FIG. 3 is a schematic plan view of a circuit substrate according to the embodiment.
FIG. 4 is a schematic plan view of a first electrode, a second electrode, and a resistor according to the embodiment.
FIG. 5 is a cross-sectional view taken along a line A-A illustrated in FIG. 4.
FIG. 6 is a view for describing laser trimming of the resistor according to the embodiment.
FIG. 7 is a view for describing an arrangement of the first electrode and the second electrode according to the embodiment.
FIG. 8 is a cross-sectional view illustrating another example of the first electrode, the second electrode, and the resistor according to the embodiment.
FIG. 9 is a cross-sectional view illustrating still another example of the first electrode, the second electrode, and the resistor according to the embodiment.
FIG. 10 is a schematic plan view of the first electrode, the second electrode, and the resistor according to another embodiment 1.
FIG. 11 is a schematic plan view of the first electrode, the second electrode, and the resistor according to another embodiment 2.
FIG. 12 is an enlarged plan view of the first comb-tooth portion and the second comb-tooth portion according to another embodiment 3.
FIG. 13 is a schematic plan view of the first electrode, the second electrode, and the resistor according to another embodiment 4.
FIG. 14 is a schematic plan view of the first electrode, the second electrode, and the resistor according to another embodiment 5.
FIG. 15 is a schematic plan view of the first electrode, the second electrode, and the resistor according to another embodiment 6.

### DESCRIPTION OF EMBODIMENTS

Since a substrate made of a ceramic has superior insulating properties, superior thermal conductivity, and the like, the substrate may be utilized as a circuit substrate for a lighting device such as an on-board lamp. The circuit substrate is provided with a resistor for adjusting a current flowing through a light emitting element such as an LED.
However, the related art described above has room for further improvement in terms of reducing an electrical resistance of the resistor.
As such, a technique to overcome the aforementioned problem and reduce the electrical resistance of the resistor has yet to be realized.
Hereinafter, embodiments of the circuit substrate and the electronic device disclosed in the present disclosure will be described with reference to the accompanying drawings. The present invention is not limited by the following embodiments. Embodiments can be appropriately combined so as not to contradict each other in terms of processing content. In the following embodiments, the same portions are denoted by the same reference signs, and redundant explanations are omitted.
In the embodiments described below, expressions such as "constant", "orthogonal", "perpendicular", and "parallel" may be used, but these expressions do not mean exactly "constant", "orthogonal", "perpendicular", and "parallel". That is, each of the expressions described above allows for deviations in, for example, manufacturing accuracy, installation accuracy, and the like.

In each of the drawings referred to below, for ease of explanation, an X-axis direction, a Y-axis direction, and a Z-axis direction that are orthogonal to each other may be defined to illustrate a rectangular coordinate system in which the Z-axis positive direction is the vertically upward direction.

In the embodiments described below, examples will be described in which the circuit substrate according to the present disclosure is applied to a lighting device, which is an example of the electronic device.

Lighting Device and Socket

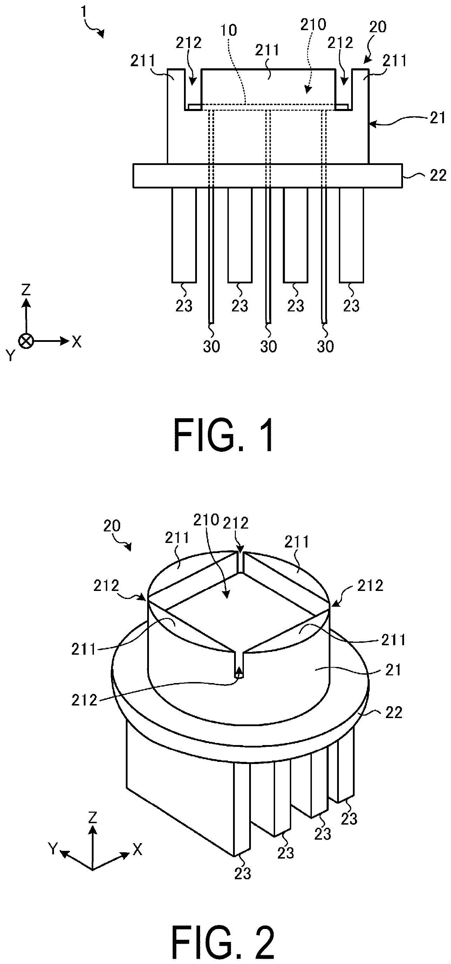

First, a configuration of the lighting device and a socket according to an embodiment will be described with reference to FIGs. 1 and 2. FIG. 1 is a schematic side view of a lighting device 1 according to the embodiment. FIG. 2 is a schematic perspective view of a socket 20 according to the embodiment.

As illustrated in FIG. 1, the lighting device 1 according to the embodiment includes a circuit substrate 10, a socket 20 for accommodating the circuit substrate 10, and a plurality of electrically conductive terminals 30 connected to the circuit substrate 10. The lighting device 1 according to the embodiment may be used, as, for example, an on-board lighting device. For example, the lighting device 1 may be used as a light source such as a rear lamp, a turn lamp, a position lamp, and a fog lamp.

As illustrated in FIGs. 1 and 2, the socket 20 includes a housing part 21, a flange part 22, and a plurality of heat dissipating fins 23.

The housing part 21 is, for example, a bottomed tubular portion having a substantially circular shape in a plan view, and is located on a surface opposite a surface on which the plurality of heat dissipating fins 23 are located in the flange part 22 described below. The housing part 21 includes a recessed portion 210 recessed from an end surface of the socket 20, specifically from a surface opposite a surface in contact with the flange part 22 of the housing part 21, toward the other end side of the socket 20. The circuit substrate 10 is accommodated in the recessed portion 210.

The recessed portion 210 includes a plurality of side wall portions 211. Each of the plurality of side wall portions 211 has, for example, an arcuate shape in a plan view, and may be arranged along a circumferential direction around the circuit substrate 10 so as to surround the circuit substrate 10. Gaps 212 are provided each between two of the plurality of side wall portions 211 adjacent to each other in the circumferential direction.

The flange part 22 is, for example, a disc-shaped portion, and may be located between the housing part 21 and the plurality of heat dissipating fins 23. The flange part 22 has a larger diameter than that of the housing part 21, and when the lighting device 1 is inserted into, for example, a mounting hole provided in the vehicle body, the flange part 22 may come into contact with a peripheral edge of the mounting hole.

A bayonet (not illustrated) for a twist lock is located on an outer peripheral surface of the housing part 21, and by rotating the socket 20 in a state where the flange part 22 is in contact with the peripheral edge of the mounting hole, the bayonet is fitted into a groove on the vehicle body side, so that the lighting device 1 may be in a state of being fixed to the vehicle body.

The plurality of heat dissipating fins 23 are located on a surface opposite a surface on which the housing part 21 is located in the flange part 22. Heat generated in the circuit substrate 10 is emitted primarily from the plurality of heat dissipating fins 23. Here, the example is given in which the socket 20 includes four heat dissipating fins 23, but the number of the heat dissipating fins 23 of the socket 20 is not limited to four.

Note that a heat transfer member (not illustrated) formed of, for example, a metal such as aluminum may be located between a bottom portion of the recessed portion 210 and the circuit substrate 10. The heat transfer member is located so as to be in contact with the circuit substrate 10 and the bottom portion of the recessed portion 210, and may transmit the heat generated in the circuit substrate 10 to the heat dissipating fins 23.

Circuit Substrate

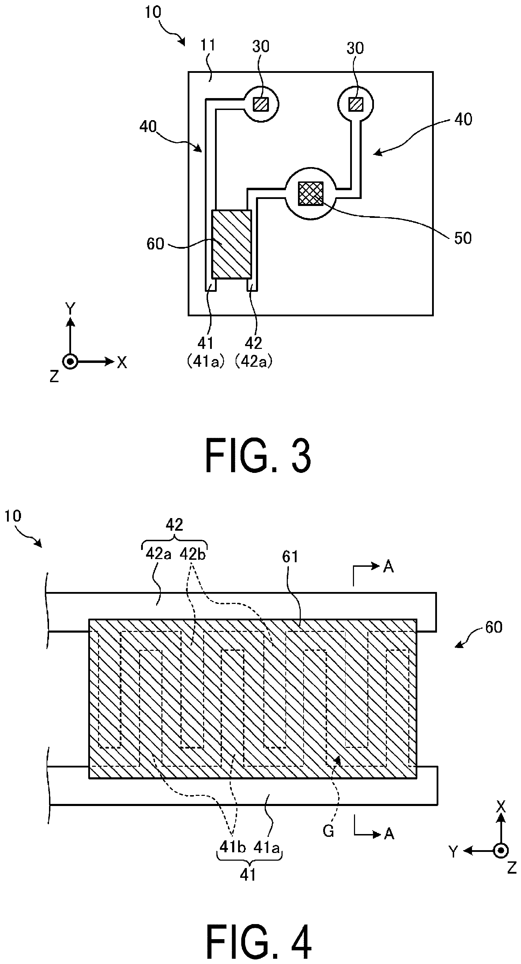

The configuration of the circuit substrate 10 according to the embodiment will be described with reference to FIG. 3. FIG. 3 is a schematic plan view of a circuit substrate 10 according to the embodiment.

As illustrated in FIG. 3, the circuit substrate 10 includes a substrate body 11 made of a ceramic. The substrate body 11 is a member having a flat plate shape including a first surface that is a circuit forming surface, a second surface located opposite the first surface, and a plurality of third surfaces, in other words, side surfaces respectively connected to the first surface and the second surface. The substrate body 11 is accommodated in the housing part 21 in a state where the second surface faces the bottom surface of the recessed portion 210, in other words, in a state where the first surface that is the circuit forming surface faces the front.

The ceramic used for the substrate body 11 may be an aluminum oxide-based ceramic, a zirconium oxide-based ceramic, a composite ceramic of aluminum oxide and zirconium oxide, a silicon nitride-based ceramic, an aluminum nitride-based ceramic, a silicon carbide-based ceramic, or a mullite ceramic.

Note that the substrate body 11 made of the aluminum oxide-based ceramic has mechanical strength required for the substrate body 11, and has superior workability. The substrate body 11 made of the aluminum nitride-based ceramic has high thermal conductivity, and thus has superior heat radiating properties.

Wiring 40 containing a metal such as copper or silver as a main constituent is located on the first surface of the substrate body 11. The wiring 40 is electrically connected to the electrically conductive terminal 30 via an electrically conductive bonding material (not illustrated) such as a brazing material or a solder. The wiring 40 may contain an insulation material such as glass.

A light emitting element 50, which is an example of an electronic component, is located on the wiring 40. The light emitting element 50 may be, for example, a light emitting diode (LED), a laser diode (LD), or the like. The wiring 40 electrically connects the electrically conductive terminal 30 and the light emitting element 50 to each other.

A first electrode 41 and a second electrode 42 are located in a middle portion of the wiring 40, in other words, a portion between the electrically conductive terminal 30 and the light emitting element 50. The first electrode 41 and the second electrode 42 are located with an interval from each other on the substrate body 11.

A first body portion 41a of the first electrode 41 and a second body portion 42a of the second electrode 42 extend in parallel to each other. Note that an example in which the first body portion 41a and the second body portion 42a extend in a Y axis direction is illustrated here. Each of the first electrode 41 and the second electrode 42 is, for example, a part of the wiring 40, and may be made of the same material as the wiring 40, for example, copper or silver.

Resistor

The resistor 60 is located between the first electrode 41 and the second electrode 42. The resistor 60 has a higher electrical resistance than that of the wiring 40 and can adjust a current flowing through the light emitting element 50.

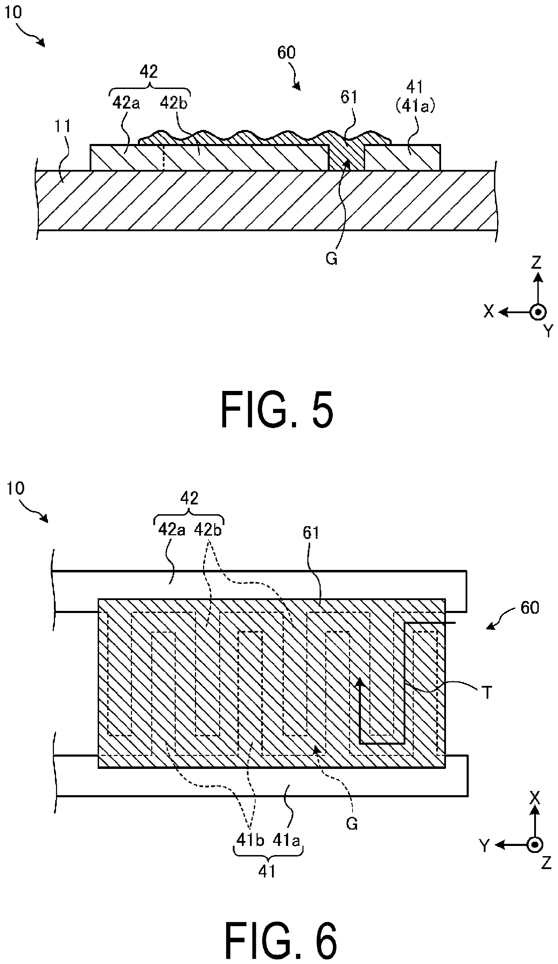

Here, a specific configuration example of the resistor 60 according to the embodiment will be described with reference to FIGs. 4 to 9. FIG. 4 is a schematic plan view of the first electrode 41, the second electrode 42, and the resistor 60 according to the embodiment. FIG. 5 is a cross-sectional view taken along a line A-A illustrated in FIG. 4.

As illustrated in FIG. 4, the resistor 60 according to the embodiment includes a resistive element 61. The resistive element 61 is a thin-film resistive element printed on the substrate body 11 and has a quadrilateral shape in a plan view. The resistive element 61 may contain, for example, an insulation material and an electrically conductive material.

In the embodiment, since the resistive element 61 contains the insulation material, the electrical resistance of the resistive element 61 can be increased. In the embodiment, a resistance value of the resistive element 61 can be adjusted by changing a compounding ratio of the insulation material and the electrically conductive material.

The insulation material may be, for example, glass and the electrically conductive material may be, for example, lanthanum hexaboride ($LaB_6$), tantalum nitride (TaN), tungsten carbide (WC), molybdenum silicide ($MoSi_2$), ruthenium oxide ($RuO_2$), copper (Cu), nickel (Ni), and constantan (55Cu-45Ni). The resistive element 61 has a higher electrical resistance than that of the wiring 40.

As illustrated in FIG. 4, each of the first electrode 41 and the second electrode 42 in contact with the resistive element 61 has a comb-tooth shape. Specifically, the first electrode 41 includes the first body portion 41a and a plurality of first comb-tooth portions 41b.

The first body portion 41a extends along a predetermined direction, for example, the Y-axis direction. Each of the plurality of first comb-tooth portions 41b extends from a side of the first body portion 41a facing the second electrode 42 along a direction intersecting a direction in which the first body portion 41a extends, for example, the X-axis direction.

The plurality of first comb-tooth portions 41b may, for example, extend from the first body portion 41a so as to be substantially parallel to each other. All of the plurality of first comb-tooth portions 41b may, for example, respectively have a substantially equal width and a length and may be located side by side at equal intervals.

As described above, the second electrode 42 includes the second body portion 42a and a plurality of second comb-tooth portions 42b. The second body portion 42a extends along a predetermined direction, for example, the Y-axis direction. Each of the plurality of second comb-tooth portions 42b extends from a side of the second body portion 42a facing the first electrode 41 along a direction intersecting a direction in which the second body portion 42a extends, for example, the X-axis direction.

The plurality of second comb-tooth portions 42b may, for example, extend from the second body portion 42a so as to be substantially parallel to each other. All of the plurality of second comb-tooth portions 42b may, for example, respectively have a substantially equal width and a length and may be located side by side at equal intervals.

In the embodiment, the first electrode 41 having the comb-tooth shape and the second electrode 42 having the comb-tooth shape mesh with each other and are located with a predetermined interval therebetween. In other words, as illustrated in FIG. 4, a gap G meandering in a plan view is formed between the first electrode 41 and the second electrode 42.

As illustrated in FIGs. 4 and 5, the resistive element 61 according to the embodiment is located so as to fill at least a part of the gap G and cover at least a part of the first electrode 41 and the second electrode 42.

In other words, in the embodiment, the resistive element 61 having a meandering shape is provided between the first electrode 41 and the second electrode 42 such that the meandering shape has a short length L along a direction in which a current flows, in other words, a short interval between both electrodes and a long length W along a direction orthogonal to the direction in which the current flows, in other words, a long length of the gap G. As described above, the electrical resistance of the resistor 60 can be reduced by disposing the resistive element 61 having the short length L and the long length W between the first electrode 41 and the second electrode 42.

This is because, since an electrical resistance R of the resistor 60 is obtained by the following equation (1), the electrical resistance R of the resistor 60 can be reduced by shortening the length L and lengthening the length W.

$$R = Rs \times L/W \quad (1)$$

Rs: sheet resistance

Here, in the embodiment, the resistive element 61 is located so as to be in contact with both the first body portion 41a of the first electrodes 41 and the second body portion 42a of the second electrodes 42. As a result, the resistive element 61 having a substantially uniform length L in substantially all regions and a longer length W can be formed between the first electrode 41 and the second electrode 42.

Thus, according to the embodiment, the electrical resistance of the resistor 60 can be reduced.

In the embodiment, since the resistive element 61 located between the first electrode 41 and the second electrode 42 is formed in the meandering shape, the resistive element 61 can be disposed in a narrow space. Thus, according to the embodiment, since an area of the circuit substrate 10 can be reduced, a manufacturing cost of the circuit substrate 10 can be reduced.

In the resistor 60 according to the embodiment, laser trimming may be performed for fine adjustment of the resistance value. The laser trimming is a method of adjusting the resistance value so as to increase the resistance value of the resistor 60 by forming a groove along a direction orthogonal to the direction in which the current flows in the resistive element 61, in other words, by shortening the length W.

In the embodiment, since the resistive element 61 located between the first electrode 41 and the second electrode 42 has the meandering shape, the laser trimming can be simply and accurately performed by forming a groove T along the gap G as illustrated in FIG. 6. FIG. 6 is a view for describing the laser trimming of the resistor 60 according to the embodiment.

In the embodiment, the resistor 60 may include one resistive element 61. In other words, in the embodiment, the integrated resistive element 61 may be located between the first electrode 41 and the second electrode 42.

As a result, the resistive element 61 having the same electrical resistance can be disposed in a narrower space. Thus, according to the embodiment, since the area of the circuit substrate 10 can be further reduced, the manufacturing cost of the circuit substrate 10 can be further reduced.

In the embodiment, since the integrated resistive element 61 is located between the first electrode 41 and the second electrode 42, deviation of the electrical resistance of the resistor 60 from a desired value can be reduced even when positional deviation of the resistive element 61 occurs when the resistive element 61 is formed by screen printing or the like.

Thus, according to the embodiment, since the yield of the circuit substrate 10 can be improved, the manufacturing cost of the circuit substrate 10 can be further reduced.

In the embodiment, since the integrated resistive element 61 is located between the first electrode 41 and the second electrode 42, the resistive element 61 itself serves as a carrier of heat, and thus the amount of heat per unit area of the resistor 60 can be reduced. Thus, according to the embodiment, the reliability of the circuit substrate 10 can be improved.

In the embodiment, as illustrated in FIG. 4, all of the plurality of first comb-tooth portions 41b and the plurality of second comb-tooth portions 42b may be covered with the resistive element 61. Thus, since the amount of heat per unit area of the resistor 60 can be further reduced, the reliability of the circuit substrate 10 can be further improved.

In the present disclosure, all of the plurality of first comb-tooth portions 41b and the plurality of second comb-tooth portions 42b need not be covered with the resistive element 61.

In the embodiment, the first comb-tooth portion 41b and the second comb-tooth portion 42b may be longer in the extending direction, the X-axis direction in the drawing, than in the width direction, the Y-axis direction in the drawing. As a result, since the length L of the resistive element 61 can be further increased, the electrical resistance of the resistor 60 can be further reduced.

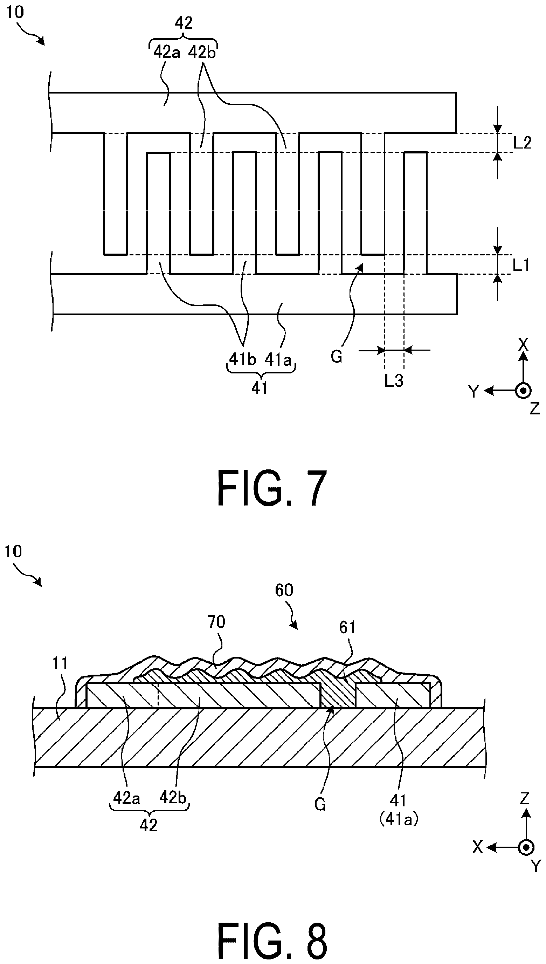

FIG. 7 is a view for describing an arrangement of the first electrode 41 and the second electrode 42 according to the embodiment. As illustrated in FIG. 7, in the embodiment, all of an interval L1 between the first body portion 41a and the second comb-tooth portion 42b, an interval L2 between the second body portion 42a and the first comb-tooth portion 41b, and an interval L3 between the first comb-tooth portion 41b and the second comb-tooth portion 42b may be substantially equal to each other.

As a result, when the above-described laser trimming is performed, one resistive element 61 (see FIG. 4) having a uniform width is cut, and thus a variation in the resistance value when the laser trimming is performed can be reduced. Thus, according to the embodiment, the laser trimming can be further accurately performed.

In the embodiment, the resistive element 61 may contain $LaB_6$. When the wiring 40 contains copper as the main constituent, migration can be reduced. On the other hand, firing in a non-oxidizing atmosphere is necessary. Thus, the resistive element 61 which is fired in the same firing furnace as the wiring 40 is also fired in the non-oxidizing atmosphere.

In the embodiment, since the resistive element 61 contains $LaB_6$, the resistance value of the resistive element 61 can be stabilized even when the resistive element 61 is fired in the non-oxidizing atmosphere. In other words, in the embodiment, since the resistive element 61 contains $LaB_6$, the resistance value of the resistor 60 can be stabilized.

On the other hand, when a proportion of $LaB_6$ in the resistive element 61 is high, the glass is reduced by the reduction action of $LaB_6$, so that peeling between the resistive element 61 and a glass layer 70 (see FIG. 8), peeling between the resistive element 61 and the wiring 40, peeling between the wiring 40 and the glass layer 70, or peeling between the wiring 40 and the substrate body 11 may occur.

However, in the embodiment, since the resistor 60 has the above-described configuration, the resistance value of the resistor 60 can be reduced, and thus, the proportion of the insulation material in the resistive element 61 can be increased, and the proportion of $LaB_6$ can be reduced. As a result, peeling between the resistive element 61 and the glass layer 70, peeling between the resistive element 61 and the wiring 40, peeling between the wiring 40 and the glass layer 70, or peeling between the wiring 40 and the substrate body 11 can be reduced.

In the embodiment, since the glass of the resistive element 61 is easily bonded to the glass layer 70 by increasing the proportion of the glass in the resistive element 61, in other words, by decreasing the proportion of $LaB_6$ in the resistive element 61, peeling between the resistive element 61 and the glass layer 70 can be reduced.

FIG. 8 is a cross-sectional view illustrating another example of the first electrode 41, the second electrode 42, and the resistor 60 according to the embodiment. In the embodiment, as illustrated in FIG. 8, the wiring 40, the first electrode 41, the second electrode 42, and the resistor 60 may be covered with the glass layer 70. The glass layer 70 may be formed, for example, for the purpose of protecting the surfaces of the wiring 40, the first electrode 41, the second electrode 42, and the resistor 60.

The glass layer 70 may be mainly composed of any one of the following systems: $X_2O\text{-}B_2O_3\text{-}SiO_2$ (X: alkali metal element), $X_2O\text{-}SiO_2\text{-}B_2O_3\text{-}Bi_2O_3$ (X: alkali metal element), and $X'O\text{-}B_2O_3\text{-}SiO_2$ (X': alkaline earth element).

Here, the main constituent in the glass layer 70 is defined as the constituent that contains 60 mass% or more of the total 100 mass% of all of the constituents constituting the glass layer 70. The glass layer 70 may contain at least one of titanium oxide and zirconium oxide in order to improve the reflectance of the glass layer 70 with respect to visible light.

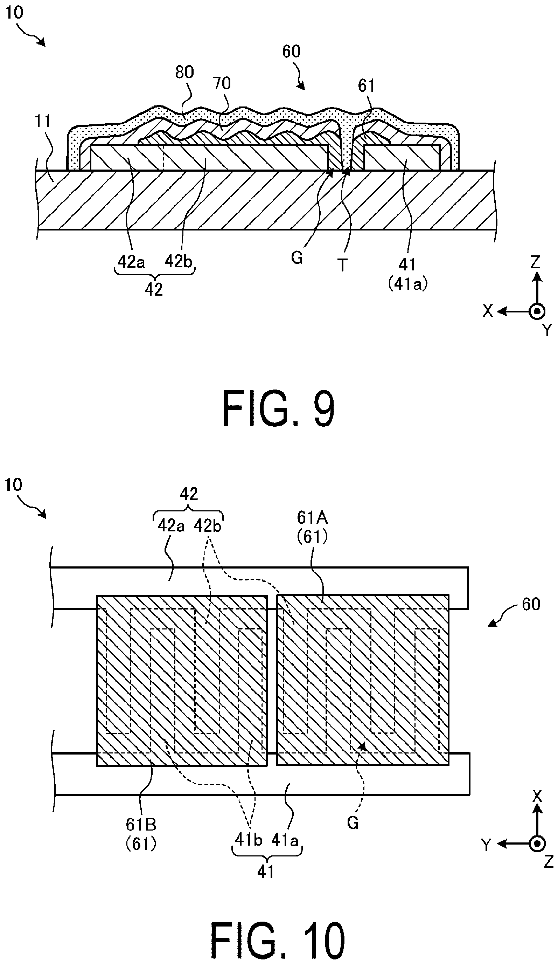

FIG. 9 is a cross-sectional view illustrating still another example of the first electrode 41, the second electrode 42, and the resistor 60 according to the embodiment. In the embodiment, as illustrated in FIG. 9, the wiring 40, the first electrode 41, the second electrode 42, the resistor 60, and the glass layer 70 may be covered with a resin layer 80. As a result, the inside of the groove T formed by the trimming is in a state of being filled with the resin.

In other words, in the embodiment, the resin layer 80 is positioned to protect the surface of the resistive element 61 exposed inside the groove T by the trimming. In the embodiment, when the resin layer 80 is further positioned on the glass layer 70, the effect of physically suppressing the peeling can be enhanced by the weight of the resin layer 80.

The resin layer 80 only needs to cover at least the groove T, and need not necessarily cover the entirety of the first electrode 41, the second electrode 42, the resistive element 61, and the glass layer 70.

Another Embodiment 1

Next, another embodiment of the present disclosure will be described with reference to FIGs. 10 to 15. FIG. 10 is a schematic plan view of the first electrode 41, the second electrode 42, and the resistor 60 according to another embodiment 1.

As illustrated in FIG. 10, in another embodiment 1, the configuration of the resistive element 61 differs from the embodiment. Specifically, in another embodiment 1, the resistive element 61 includes two resistive elements 61A and 61B.

In the first embodiment 1, as in the above-described embodiment, each of the resistive elements 61A and 61B is located so as to be in contact with both the first body portion 41a of the first electrode 41 and the second body portion 42a of the second electrode 42.

Also in this case, as in the above-described embodiment, the resistive element 61 having a substantially uniform length L in substantially all regions and a longer length W can be formed between the first electrode 41 and the second electrode 42. Thus, according to another embodiment 1, the electrical resistance of the resistor 60 can be reduced.

In the example of FIG. 10, an example is described in which the resistive element 61 includes the two resistive elements 61A and 61B, but the resistive element 61 may include three or more resistive elements.

Another Embodiment 2

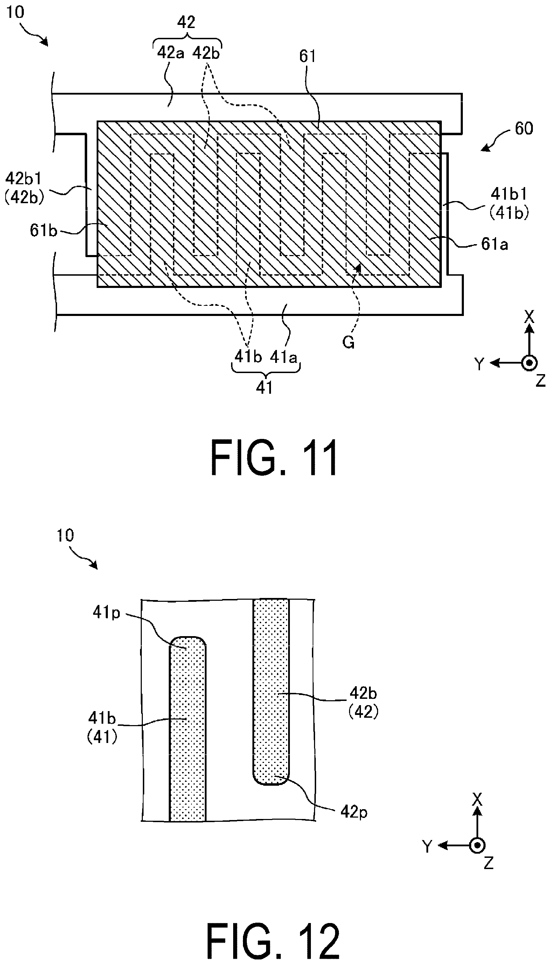

FIG. 11 is a schematic plan view of the first electrode 41, the second electrode 42, and the resistor 60 according to another embodiment 2. As illustrated in FIG. 11, in another embodiment 2, the configurations of the first electrode 41 and the second electrode 42 differ from the embodiment.

Specifically, in another embodiment 2, among the plurality of first comb-tooth portions 41b, a first comb-tooth portion 41b1 overlapping an end portion 61a of the resistive element 61 has a wider width than the other first comb-tooth portions 41b. As a result, deviation of the electrical resistance of the resistor 60 from a desired value can be reduced even when positional deviation of the resistive element 61 occurs when the resistive element 61 is formed by screen printing or the like.

Thus, according to another embodiment 2, since the yield of the circuit substrate 10 can be improved, the manufacturing cost of the circuit substrate 10 can be further reduced.

In another embodiment 2, among the plurality of second comb-tooth portions 42b, a second comb-tooth portion 42b1 overlapping an end portion 61b of the resistive element 61 has a wider width than the other second comb-tooth portions 42b. As a result, deviation of the electrical resistance of the resistor 60 from a desired value can be reduced even when positional deviation of the resistive element 61 occurs when the resistive element 61 is formed by screen printing or the like.

Thus, according to another embodiment 2, since the yield of the circuit substrate 10 can be improved, the manufacturing cost of the circuit substrate 10 can be further reduced.

In the example illustrated in FIG. 11, an example is described in which the first comb-tooth portion 41b1 and the second comb-tooth portion 42b1 has a wider width than the other first comb-tooth portion(s) 41b and the other second comb-tooth portion(s) 42b, respectively, but the present disclosure is not limited to this example.

For example, only the first comb-tooth portion 41b1 may have a wider width than the other first comb-tooth portions 41b, or only the second comb-tooth portion 42b 1 may have a wider width than the other second comb-tooth portions 42b.

Another Embodiment 3

FIG. 12 is an enlarged plan view of the first comb-tooth portion 41b and the second comb-tooth portion 42b according to another embodiment 3. As illustrated in FIG. 12, in another embodiment 3, each of a tip portion 41p of the first comb-tooth portion 41b and a tip portion 42p of the second comb-tooth portion 42b has a round shape.

As a result, since thermal stress is less likely to occur in the vicinity of the tip portions 41p and 42p, the reliability of the circuit substrate 10 can be improved.

In the example illustrated in FIG. 12, an example is described in which each of the tip portion 41p of the first comb-tooth portion 41b and the tip portion 42p of the second comb-tooth portion 42b has a round shape, but the present disclosure is not limited to this example. For example, only the tip portion 41p of the first comb-tooth portion 41b may have a round shape, or only the tip portion 42p of the second comb-tooth portion 42b may have a round shape.

Among the plurality of first comb-tooth portions 41b, only the tip portions 41p of some first comb-tooth portions 41b may have a round shape, or among the plurality of second comb-tooth portions 42b, only the tip portions 42p of some second comb-tooth portions 42b may have a round shape.

Other Embodiments 4 and 5

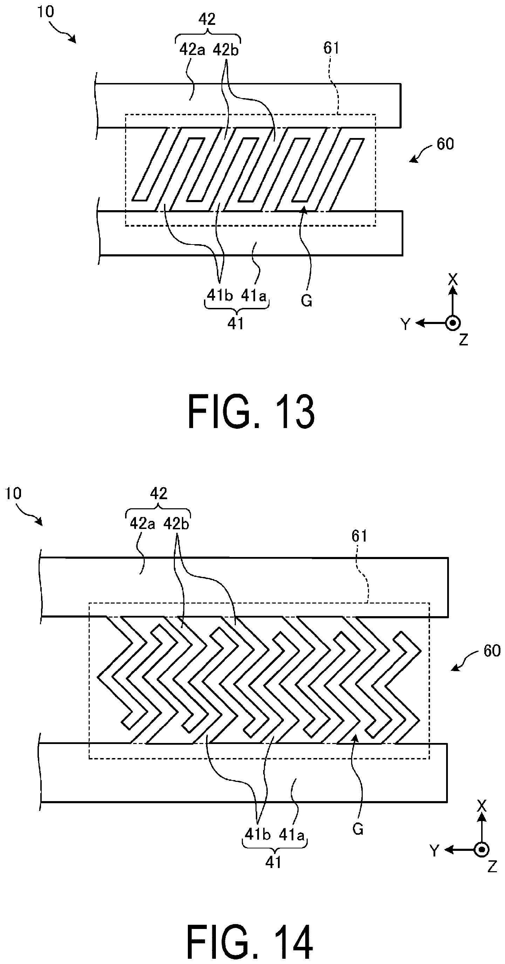

FIG. 13 is a schematic plan view of the first electrode 41, the second electrode 42, and the resistor 60 according to another embodiment 4. Note that, in the following drawings, the resistive element 61 of the resistor 60 is illustrated with a dashed line for the purpose of facilitating understanding.

As illustrated in FIG. 13, in another embodiment 4, the configurations of the first electrode 41 and the second electrode 42 differ from the embodiment. Specifically, in another embodiment 4, the first comb-tooth portions 41b extend along a direction oblique to the first body portion 41a, and the second comb-tooth portions 42b extend along a direction oblique to the second body portion 42a.

As a result, since the length of the gap G formed between the first electrode 41 and the second electrode 42 can be further increased, the resistive element 61 having a further increased length W can be formed between the first electrode 41 and the second electrode 42. Thus, according to another embodiment 4, the electrical resistance of the resistor 60 can be further reduced.

In the present disclosure, a means for further increasing the length of the gap G is not limited to the example illustrated in FIG. 13. FIG. 14 is a schematic plan view of the first electrode 41, the second electrode 42, and the resistor 60 according to another embodiment 5 of the embodiment. As illustrated in FIG. 14, each of the first comb-tooth portions 41b and the second comb-tooth portions 42b may have a zigzag shape.

As a result, since the length of a gap G formed between the first electrode 41 and the second electrode 42 can be further increased, the resistive element 61 having a further increased length W can be formed between the first electrode 41 and the second electrode 42. Thus, according to another embodiment 5, the electrical resistance of the resistor 60 can be further reduced.

Another Embodiment 6

In the embodiment described above, an example is illustrated in which all of the plurality of first comb-tooth portions 41b respectively have the substantially equal width and length and all of the plurality of second comb-tooth portions 42b respectively have a substantially equal width and length, but the present disclosure is not limited to this example.

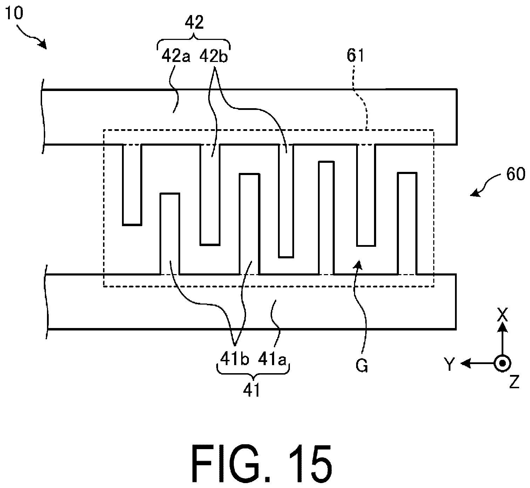

FIG. 15 is a schematic plan view of the first electrode 41, the second electrode 42, and the resistor 60 according to another embodiment 6 of the embodiment. As illustrated in FIG. 15, the plurality of first comb-tooth portions 41b may have widths and lengths different from each other, and the plurality of second comb-tooth portions 42b may have widths and lengths different from each other.

As a result, since the frequency of a current noise due to self-inductance can be dispersed in the wiring 40, the noise generated in the circuit substrate 10 can be reduced.

The circuit substrate 10 according to the embodiment includes the substrate body 11 made of a ceramic, the wiring 40 located on the substrate body 11, and the resistor 60 interposed in the wiring 40 and having a higher electrical resistance than the wiring 40. The wiring 40 includes the first electrode 41 and the second electrode 42. The first electrode 41 includes the first body portion 41a and the plurality of first comb-tooth portions 41b each extending from the first body portion 41a in a direction intersecting a direction in which the first body portion 41a extends. The second electrode 42 includes the second body portion 42a and the plurality of second comb-tooth portions 42b each extending from the second body portion 42a in a direction intersecting a direction in which the second body portion 42a extends, and has the comb-tooth shape located to mesh with a comb-tooth shape of the first electrode 41 with an interval therebetween. The resistor 60 includes the resistive element 61 located in contact with both the first body portion 41a of the first electrode 41 and the second body portion 42a of the second electrode 42. As a result, the electrical resistance of the resistor 60 can be reduced.

Note that the electronic device on which the circuit substrate according to the present disclosure is mounted is not limited to the lighting device and is applicable to various electronic devices other than the lighting device.

For example, the electronic device according to the present disclosure is applicable to a flowmeter, a display monitor mounted on such as a smart watch, a power module such as an inverter, a converter, or the like, a power semiconductor such as on-board power control unit, battery components, secondary battery components, air conditioning systems (particularly for on-board applications), optical communication devices, laser projectors such as laser cinemas, laser machines, various sensor components, optical pickup components used for reading and writing a digital versatile disk (DVD) or a compact disk (CD), laser diode components, laser diode components, a central processing unit (CPU), a graphics processing unit (GPU), a tensor processing unit (TPU), and the like.

Further effects and variations can be easily derived by those skilled in the art. Thus, a wide variety of aspects of the present invention are not limited to the specific details and representative embodiment represented and described above. Accordingly, various changes are possible without departing from the spirit or scope of the general inventive concepts defined by the appended claims and their equivalents.

REFERENCE SIGNS

1 Lighting device
10 Circuit substrate
11 Substrate body
20 Socket
21 Housing part
22 Flange part
23 Heat dissipating fin
30 Electrically conductive terminal
40 Wiring
41 First electrode
41a First body portion
41b, 41b 1 First comb-tooth portion
41p Tip portion
42 Second electrode
42a Second body portion
42b, 42b1 Second comb-tooth portion
42p Tip portion
50 Light emitting element
60 Resistor
61, 61A, 61B Resistive element
61a, 61b End portion
70 Glass layer
80 Resin layer
L1 to L3 Interval
T Groove

## Claims

1. A circuit substrate comprising:

    a substrate body made of a ceramic;
    wiring located on the substrate body;
    a resistor interposed in the wiring and having a higher electrical resistance than the wiring, wherein
    the wiring comprises

        a first electrode comprising a first body portion and a plurality of first comb-tooth portions each extending from the first body portion in a direction intersecting a direction in which the first body portion extends, and
        a second electrode comprising a second body portion and a plurality of second comb-tooth portions each extending from the second body portion in a direction intersecting a direction in which the second body portion extends and has a comb-tooth shape located to mesh with a comb-tooth shape of the first electrode with an interval, and

the resistor comprises a resistive element located in contact with both the first body portion of the first electrode and the second body portion of the second electrode.

2. The circuit substrate according to claim 1, wherein the resistor comprises one resistive element.

3. The circuit substrate according to claim 1 or 2, wherein
all of an interval between the first body portion and the second comb-tooth portion, an interval between the second body portion and the first comb-tooth portion, and an interval between the first comb-tooth portion and the second comb-tooth portion are substantially equal to each other.

4. The circuit substrate according to any one of claims 1 to 3, wherein
all of the plurality of first comb-tooth portions and all of the plurality of second comb-tooth portions are covered with the resistive element.

5. The circuit substrate according to any one of claims 1 to 4, wherein
a tip portion of the first comb-tooth portion and a tip portion of the second comb-tooth portion each have a round shape.

6. The circuit substrate according to any one of claims 1 to 5, wherein
the first comb-tooth portion and the second comb-tooth portion are longer in an extending direction than in a width direction.

7. The circuit substrate according to any one of claims 1 to 6, wherein
among the plurality of first comb-tooth portions, a first comb-tooth portion overlapping an end portion of the resistive element has a wider width than another first comb-tooth portion.

8. The circuit substrate according to any one of claims 1 to 7, wherein
among the plurality of second comb-tooth portions, a second comb-tooth portion overlapping an end portion of the resistive element has a wider width than another second comb-tooth portion.

9. The circuit substrate according to any one of claims 1 to 8, wherein

the first comb-tooth portion extends along a direction oblique to the first body portion, and the second comb-tooth portion extends along a direction oblique to the second body portion.

10. The circuit substrate according to any one of claims 1 to 9, wherein
the first comb-tooth portion and the second comb-tooth portion each have a zigzag shape.

11. The circuit substrate according to any one of claims 1 to 10, wherein
the resistive element contains lanthanum hexaboride ($LaB_6$).

12. The circuit substrate according to any one of claims 1 to 11, further comprising a glass layer configured to cover the wiring and the resistive element.

13. The circuit substrate according to any one of claims 1 to 12, wherein

the resistive element comprises a groove, and the circuit substrate further comprises a resin layer configured to cover at least the groove.

14. An electronic device comprising:

the circuit substrate according to any one of claims 1 to 13; and
an electronic component located on the substrate body and connected to the wiring.

# FIG. 1

# FIG. 2

# FIG. 3

# FIG. 4

FIG. 5

FIG. 6

# FIG. 7

# FIG. 8

# FIG. 9

# FIG. 10

FIG. 11

FIG. 12

FIG. 13

FIG. 14

FIG. 15

## INTERNATIONAL SEARCH REPORT

International application No.

**PCT/JP2022/030296**

### A. CLASSIFICATION OF SUBJECT MATTER

***H05K 1/16***(2006.01)i; ***H01C 1/146***(2006.01)i; ***H01C 7/00***(2006.01)i
FI:  H05K1/16 C; H01C1/146; H01C7/00 300

According to International Patent Classification (IPC) or to both national classification and IPC

### B. FIELDS SEARCHED

Minimum documentation searched (classification system followed by classification symbols)

H05K1/16; H01C1/146; H01C7/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 61-154104 A (TOSHIBA CORP) 12 July 1986 (1986-07-12) | 1-4, 6 |
| | p. 2, left column, line 14 to p. 3, left column, line 10 | |
| Y | p. 2, left column, line 14 to p. 3, left column, line 10 | 1-3, 5-6, 7-8, 11-14 |
| A | p. 2, left column, line 14 to p. 3, left column, line 10 | 9-10 |
| Y | JP 63-164201 A (IBIDEN CO LTD) 07 July 1988 (1988-07-07) | 1-3, 5-8, 11-14 |
| | p. 2, lower left column, line 1 to p. 4, left column, line 16, fig. 1 | |
| A | p. 2, lower left column, line 1 to p. 4, left column, line 16, fig. 1 | 4, 9-10 |
| Y | JP 63-208201 A (IBIDEN CO LTD) 29 August 1988 (1988-08-29) | 5 |
| | p. 4, upper left column, line 1 to p. 4, upper left column, line 8, fig. 2 | |
| Y | JP 2000-208895 A (DENSO CORP) 28 July 2000 (2000-07-28) | 11-13 |
| | paragraphs [0024], [0026], [0029]-[0030], fig. 1-2 | |
| Y | WO 2021/065323 A1 (KYOCERA CORPORATION) 08 April 2021 (2021-04-08) | 14 |
| | paragraph [0023], fig. 3 | |

☑ Further documents are listed in the continuation of Box C.　　☑ See patent family annex.

| | | |
|---|---|---|
| * | Special categories of cited documents: | |
| "A" | document defining the general state of the art which is not considered to be of particular relevance | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **12 October 2022** | **25 October 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**EP 4 391 738 A1**

**INTERNATIONAL SEARCH REPORT**

| International application No. |
|---|
| **PCT/JP2022/030296** |

**C.    DOCUMENTS CONSIDERED TO BE RELEVANT**

| Category* | Citation of document, with indication, where appropriate, of the relevant passages | Relevant to claim No. |
|---|---|---|
| A | JP 4-132946 A (MATSUSHITA ELECTRIC IND CO LTD) 07 May 1992 (1992-05-07) entire text, all drawings | 1-14 |

Form PCT/ISA/210 (second sheet) (January 2015)

**19**

## INTERNATIONAL SEARCH REPORT
### Information on patent family members

| | International application No. |
|---|---|
| | **PCT/JP2022/030296** |

| Patent document cited in search report | | | Publication date (day/month/year) | Patent family member(s) | Publication date (day/month/year) |
|---|---|---|---|---|---|
| JP | 61-154104 | A | 12 July 1986 | (Family: none) | |
| JP | 63-164201 | A | 07 July 1988 | (Family: none) | |
| JP | 63-208201 | A | 29 August 1988 | (Family: none) | |
| JP | 2000-208895 | A | 28 July 2000 | (Family: none) | |
| WO | 2021/065323 | A1 | 08 April 2021 | (Family: none) | |
| JP | 4-132946 | A | 07 May 1992 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9326540 A